# EUROPEAN PATENT APPLICATION

(11) **EP 1 577 947 A1**
(43) Date of publication of application: **21.09.2005**
(21) Application number: 05102037.8
(22) Date of filing: 15.03.2005
(51) Int. Cl.: H01L 23/552

(54) **Semiconductor device comprising an encapsulating material that attenuates electromagnetic interference**

(30) Priority: 16.03.2004 US 801738
(71) Applicant: TEXAS INSTRUMENTS INCORPORATED, Dallas, Texas 75265 (US)
(72) Inventor: Salzman, James, Texas 75409-640, Anna, Texas 75409-6406 (US); Panasik, Carl, Texas 75044-786, Garland (US)
(74) Representative: Holt, Michael

(57) **Abstract**

In one embodiment, an integrated circuit structure 10 includes one or more integrated circuit elements 14, 22, 26 operable to generate an electromagnetic field when an electric current is applied to the integrated circuit element. The structure 10 also includes an encapsulating compound 28 substantially surrounding the one or more integrated circuit elements 14, 22, 26. The encapsulating compound 28 includes a packaging material 30 and an electromagnetic field-attenuating material 32 operable to attenuate the electromagnetic field emitted by one or more of the integrated circuit elements 14,22,26. The electromagnetic field-attenuating material 32 is disposed within at least a portion of the packaging material 30.

## Description

### Field Of The Invention

This invention relates generally to integrated circuits and more particularly to a system and method for attenuating electromagnetic interference.

### Background Of The Invention

Electrical devices generally emit electrical fields, magnetic fields, or a combination of both (electromagnetic fields). For example, an integrated circuit structure (e.g., an integrated circuit chip) within an electrical device may emit one or more electrical fields, magnetic fields, or electromagnetic fields, which may result in the electrical device emitting such one or more fields. An electromagnetic field emitted from one electrical device may interfere with another electrical device. This interference may be referred to as electromagnetic interference (EMI). As an example, electrical devices may emit radio frequency (RF) signals, microwave signals, or other electromagnetic signals, which may interfere with other electrical devices.

Additionally, the electronics industry has seen an increase in clock speeds of electrical devices, use of RF signals in electrical devices, and integration of functions in integrated circuit chips. These factors have resulted in increased EMI. The United States Federal Communications Commission (FCC) and similar agencies of other countries may set limit on the acceptable levels of EMI signals an electrical device may emit. Current solutions for limiting EMI include encasing electrical devices in special metallic shielding (e.g., a metal casing or a plastic casing sprayed with metallic paint), often referred to as a Faraday shield. At the integrated circuit structure level, solutions include enclosing entire integrated circuit chips in metal. However, using the metal casing is generally an expensive solution, which may also present certain limitations in the design and manufacture of electrical devices. Additionally, spraying a plastic casing with a metallic paint may be costly and often adds a burdensome step to the manufacture of electrical devices.

### Summary Of The Invention

According to the present invention, certain disadvantages and problems associated with previous techniques for attenuating EMI.
In one embodiment, an integrated circuit structure includes one or more integrated circuit elements operable to generate an electromagnetic field when an electric current is applied to the integrated circuit element. The structure also includes an encapsulating compound substantially surrounding the one or more integrated circuit elements. The encapsulating compound includes a packaging material and an electromagnetic field-attenuating material operable to attenuate the electromagnetic field emitted by one or more of the integrated circuit elements. The electromagnetic field-attenuating material is disposed within at least a portion of the packaging material.

Particular embodiments of the present invention may provide one or more technical advantages. In certain embodiments, the present invention may attenuate electromagnetic fields emitted by integrated circuit elements of an integrated circuit structure (e.g., an integrated circuit chip), possibly attenuating electromagnetic field emissions from the integrated circuit structure and the interference caused by those electromagnetic field emissions. For example, integrated circuit chips are being clocked at higher frequencies, often resulting in substantial spectral energy being generated from the integrated circuit chips. In certain embodiments, including an electromagnetic field-attenuating material in the encapsulating compound of an integrated circuit structure may attenuate the spectral energy and reduce the potential for interference caused by this energy. As another example, an integrated circuit chip may include circuits or other integrated circuit elements that are relatively close to one another (e.g., metal lines that are close to one another). The present invention may help reduce or eliminate undesirable electromagnetic coupling from one metal line to another on or within the integrated circuit chip.

In certain embodiments, the present invention reduces or eliminates the need for the often-expensive special metallic housing or metallic spray-paint enclosing an electrical device. Instead, certain embodiments of the present invention provide a relatively low-cost addition to typical package molding that offers electrical benefits to the normal packaging activity. For example, the present invention may reduce overall EMI by reducing EMI at the package level rather than at the system level (e.g., by surrounding an electrical device in a metal casing creating a Faraday shield). In certain embodiments, the present invention may provide a more cost-effective solution than enclosing entire integrated circuit structures (e.g., an integrated circuit chip) in metal. In certain embodiments, the present invention may allow one or more integrated circuit structures to be placed closer to one another, on a printed circuit board for example, by reducing or eliminating electromagnetic fields emitted from each integrated circuit structure. Additionally, in particular embodiments, the present invention is less sensitive to integrated circuit fabrication variations than previous techniques such as balanced interconnect topology techniques, for example.

### Brief Description Of The Drawings

FIG. 1 illustrates a cross-sectional view of an example integrated circuit structure for attenuating electromagnetic interference;
FIG. 2 illustrates an exploded view of a portion of FIG. 1, illustrating example attenuation of electromagnetic fields of integrated circuit elements of an integrated circuit structure;
FIG. 3 illustrates a top view of an example integrated circuit structure for attenuating EMI; and
FIG. 4 illustrates an example method for forming an integrated circuit structure for attenuating electromagnetic interference, such as the example structure described with reference to FIGS. 1-3.

### Description of Example Embodiments

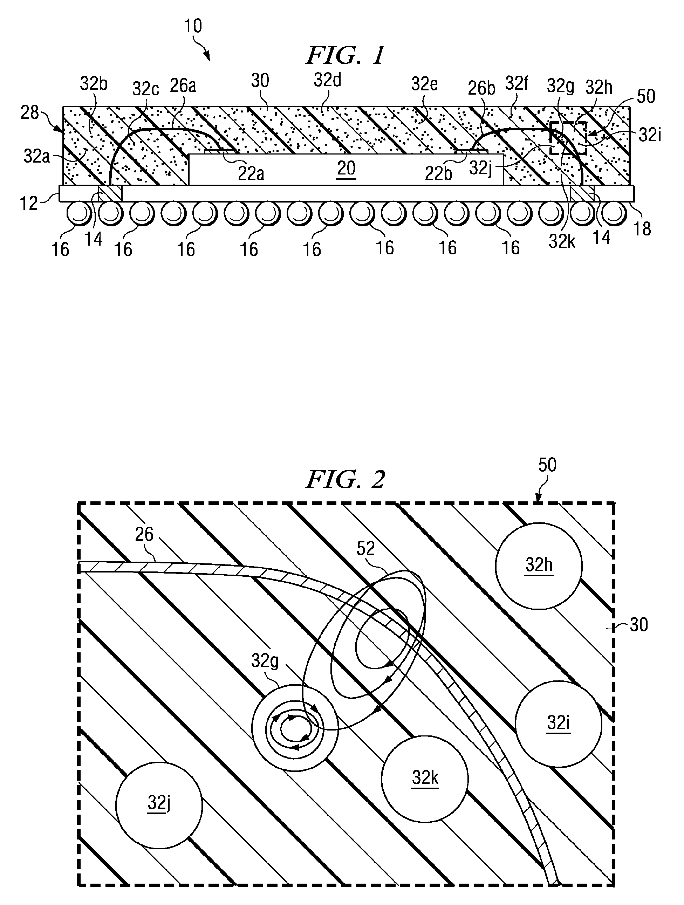

FIG. 1 illustrates a cross-sectional view of an example integrated circuit structure 10 for attenuating EMI. Structure 10 includes an integrated circuit package such as an integrated circuit chip. Structure 10 may be mounted on a printed circuit board and incorporated in an electrical device to provide certain functionality, or structure 10 may be used for any other suitable purposes.

In the illustrated embodiment, structure 10 includes an integrated circuit die 20. Although a single die 20 is illustrated, the present invention contemplates structure 10 including any suitable number of dies 20, according to particular needs. Die 20 may have any suitable size and shape, according to particular needs. Die 20 may include one or more bond pads 22. For example, bond pads 22 may be deposited or otherwise formed on a surface 22 of die 20. Although bond pads 22 are shown as being raised from surface 22 of die 20, the bond pads 22 may be deposited or otherwise formed on, within, or below surface 24 of die 20, or otherwise be associated with die 20 according to particular needs. In one embodiment, bond pads 22 have an area of approximately 100µ*m* x 100µ*m*, although the bond pads 22 may have any suitable size and shape. Although described as bond pads, bond pads 22 may otherwise be or include any suitable component for making an electrical connection within, into, or out of structure 10.

In certain embodiments, structure 10 includes a silicon, ceramic, fiberglass, or other substrate layer 12 to which die 20 is mounted. Substrate layer 12 may include circuitry associated with integrated circuit structure 10 and may be surrounded by, for example, a dielectric or other suitable material. In certain embodiments, substrate layer 12 may comprise a standard laminate material. Substrate layer 12 may have any suitable dimensions according to particular needs. Substrate layer 12 may include one or more leads 14, for use in providing electrical connections within, into, or out of structure 10 for example.

In certain embodiments, one or more solder bumps 16 are coupled to a surface 18 of substrate layer 12. For example, solder bumps 16 may be for use in coupling structure 10 to a printed circuit board or other suitable structure to provide electrical connectivity between circuitry associated with the printed circuit board or other suitable structure and circuitry associated with structure 10. For example, solder bumps 16 may contact metal or other conductive material at both the printed circuit board or other suitable structure and substrate layer 12 such that solder bumps 16 may provide electrical conductivity between circuitry associated with the printed circuit board or other suitable structure and structure 10. For example, solder bumps 16 may be used for power and ground connections, for signal interfaces, or for other suitable purposes.

In certain embodiments, solder bumps 16 may include tin-lead, high lead, or may be lead free, copper, aluminum, tungsten, or any other suitable metal or metal alloy. The present invention contemplates solder bumps 16 including any suitable material according to particular needs. Solder bumps 16 may have any suitable shape and material density, and although solder bumps 16 are illustrated as being the same size, solder bumps 16 may vary in size if appropriate. Additionally, although a specific number of solder bumps 16 are illustrated, structure 10 may include any suitable number of solder bumps 16 according to particular needs. Furthermore, solder bumps 16 may have any suitable pitch (i.e. center-to-center separation between solder bumps 16). Although solder bumps 16 are illustrated, the present invention contemplates any suitable components being coupled to substrate layer 12 for coupling structure 10 to a printed circuit board or other suitable structure to provide electrical connectivity between circuitry associated with the printed circuit board or other suitable structure and circuitry associated with structure 10, such as die 20. Furthermore, although the embodiment of structure 10 illustrated in FIG. 1 includes a ball grid array (BGA)-type integrated circuit structure 10, the structure 10 may include any suitable type of integrated circuit structure according to particular needs.

Structure 10 may also include one or more conductive connectors 26, each of which couple portions of structure 10. For example, a conductive connector 26 may couple a bond pad 22 to one or more corresponding leads 14 or other suitable portions of structure 10. In certain embodiments, conductive connectors 26 include gold or other bond wires, although the present invention contemplates conductive connectors 26 including any suitable component for providing a electrical connection between portions of structure 10.

In certain embodiments, bond pads 22, conductive connectors 26, leads 14, or other suitable components of structure 10 may be referred to as integrated circuit elements. For purposes of this description, an integrated circuit element may include at least any component of structure 10 capable of emitting an electrical field, a magnetic field, an electromagnetic field, or other emissions capable of causing interference when an electric current is applied to the integrated circuit element. For example, conductive connectors 26 may emit an electromagnetic field when an electric current is applied to conductive connectors 26. As another example, bond pads 22 may emit an electromagnetic field when an electric current is applied to bond pads 22. As yet another example, leads 14 may emit an electromagnetic field when an electric current is applied to leads 14.

These electromagnetic fields may cause interference within and/or external to structure 10. The interference cause by these electromagnetic fields may be referred to as EMI. For example, conductive connector 26a may emit an electromagnetic field that may interfere with conductive connector 26b. Similarly, conductive connector 26b may emit an electromagnetic field that may interfere with conductive connector 26a. In one embodiment, this EMI may be referred to as electromagnetic coupling of conductive connectors 26. It may be desirable to attenuate EMI associated with structure 10. As another example, an electromagnetic field produced by conductive connector 26 may interfere with an electrical device external to structure 10. The term "attenuate" as it is used throughout this description generally refers to a reduction or elimination of something. Thus, to attenuate EMI means to reduce or eliminate EMI and to attenuate an electromagnetic field means to reduce or eliminate the electromagnetic field.

Structure 10 includes an encapsulating compound 28 substantially surrounding one or more integrated circuit elements of structure 10. For example, in the illustrated embodiment of structure 10, encapsulating compound 28 substantially surrounds at least die 20, bond pads 22, and conductive connectors 26. Encapsulating compound 28 may be formed, molded, deposited or otherwise provided on a bonded chip (e.g., structure 10), flipped chip or other suitable structure in any suitable manner, such as by injection molding or by dropping globs of encapsulating compound 28 on the bonded or flipped chip. In certain embodiments, encapsulating compound 28 includes a packaging material 30. Packaging material 30 may include an electrically insulating material, such as plastic, epoxy, glass, or wax, capable of being formed or molded into a desired shape.

Encapsulating compound 28 also includes an electromagnetic field-attenuating material 32 dispersed within at least a portion of packaging material 30. For example, electromagnetic field-attenuating material 32 may be mixed into at least a portion of packaging material 30 of encapsulating compound 28. Electromagnetic field-attenuating material 32 is generally operable to attenuate the electrical fields, magnetic fields, or electromagnetic fields generated by one or more integrated circuit elements of structure 10, such as leads 14, bond pads 22, or conductive connectors 26.

Including electromagnetic field-attenuating material 32 in encapsulating compound 28 may help attenuate EMI within structure 10 and attenuate the electromagnetic energy being emitted from structure 10. For example, in embodiments in which structure 10 includes at least two conductive connectors 26, electromagnetic field-attenuating material 32 of encapsulating compound 28 may be operable to attenuate electromagnetic coupling of conductive connectors 28. As another example, in embodiments in which structure 10 is mounted on a printed circuit board that includes multiple integrated circuit structures, electromagnetic field-attenuating material 32 may help attenuate the electromagnetic energy being emitted from structure 10, possibly attenuating EMI with another integrated structure on the printed circuit board. As yet another example, electromagnetic field-attenuating material 32 may help attenuate an electromagnetic field from being emitted from an electrical device in which structure 10 is incorporated, which may reduce or eliminate EMI between that electrical device and other electrical devices.

Electromagnetic field-attenuating material 32 may include a ferrite material such iron or iron oxide. Ferrite materials may include homogenous ceramic materials comprising various oxides. Typically, iron is the main component of a ferrite material, although this may not be required. Although electromagnetic field-attenuating material is primarily described as including a ferrite material, the present invention contemplates electromagnetic field-attenuating material 32 including any suitable material capable of attenuating an electromagnetic field, such as a Nickel-Cobalt material, a Barium material, or a Strontium Oxide material. In certain embodiments, electromagnetic field-attenuating material 32 includes a material of relatively high magnetic permeability which concentrates a magnetic-flux density and of high electrical resistivity which limits the amount of electric current flow in the material. In certain embodiments, encapsulating compound 28 may include particles of calcium silicate in addition to or instead of electromagnetic field-attenuating material 32, which may help minimize dielectric loss. This may be desirable, for example, when capacitive coupling is an issue between integrated circuit elements of the circuit or circuits. In certain embodiments, electromagnetic field-attenuating material 32 exhibits low energy losses, is efficient, and/or functions at any suitable range of frequencies, possibly including relatively high frequencies (e.g., approximately 1*MHz* to approximately 1*GHz*, or higher).

The type of electromagnetic field-attenuating material 32 included in encapsulating compound 28 may affect the amount and/or type of field that is attenuated. For example, certain types of electromagnetic field-attenuating material 32 may be more suitable for attenuating electrical fields, while others may be more suitable for attenuating magnetic fields. As another example, certain types of electromagnetic field-attenuating material 32 may be equally suitable for attenuating both an electrical field component and a magnetic field component of an electromagnetic field. Additionally, the type of electromagnetic field-attenuating material 32 used may affect the frequencies at which electromagnetic fields can be attenuated.

In certain embodiments, before it is incorporated into packaging material 30, electromagnetic field-attenuating material 32 may be in a powder or other granular form comprising a plurality of electromagnetic field-attenuating particles 32a, 32b, 32c, and so on. In such embodiments, this powder may be mixed with packaging material 30 before molding and the mixture may then be molded into a desired shape to form encapsulating compound 28. Furthermore, although a particular number of electromagnetic field-attenuating particles 32 are illustrated, the present invention contemplates encapsulating compound 28 including any suitable number of electromagnetic field-attenuating particles 32, according to particular needs. Additionally, although electromagnetic field-attenuating particles 32 are illustrated as having a particular size and shape, the present invention contemplates electromagnetic field-attenuating particles 32 each having any suitable size and shape, according to particular needs.

In certain embodiments, the orientation, size, and shape of particles 32 may affect the ability of electromagnetic field-attenuating material 32 to attenuate electromagnetic fields. For example, some or all of particles 32 may be shaped and/or oriented in such a way that they are more effective at attenuating magnetic fields emitted by integrated circuit elements of structure 10. In certain embodiments, this may be accomplished by having a magnetic field present when encapsulating compound 28, including packaging material 30 and electromagnetic field-attenuating material 32, is at an increased temperature for formation or molding. Particles 32 may orient themselves appropriately while encapsulating material 28 is at the increased temperature, and when material 28 cools, particles 32 should be substantially appropriately oriented. In embodiments in which electromagnetic field-attenuating material is in powder, particulate or other granular form, one or more of the plurality of electromagnetic field-attenuating particles 32 are operable to attenuate EMI by attenuating electromagnetic fields of one or more integrated circuit elements of structure 10 (e.g., conductive connectors 26). The present invention contemplates electromagnetic field-attenuating material 32 being disposed within at least a portion of encapsulating compound 28 in any suitable manner according to particular needs.

FIG. 2 illustrates an exploded view of a portion 50 of FIG. 1, illustrating example attenuation of electromagnetic fields of integrated circuit elements of integrated circuit structure 10. As illustrated in FIG. 2, encapsulating compound 28 includes packaging material 30 and electromagnetic field-attenuating material 32, shown as particles 32g, 32h, 32i, 32j, and 32k. As illustrated in FIG. 2, encapsulating compound 28 substantially surrounds conductive connector 26. In the illustrated embodiment, conductive connectors 26 emit an electromagnetic field 52. Although electromagnetic field 52 is illustrated as being a series of ellipses moving in a clockwise direction, this is merely for illustrative purposes and is not intended in a limiting sense.

One or more of electromagnetic field-attenuating particles 32 such as particle 32g may each be operable to attenuate EMI by attenuating electromagnetic field 52. For example, one or more of electromagnetic field-attenuating particles 32 such as particle 32g may each be operable to absorb or block at least portion of electromagnetic field 52. In a particular example, electromagnetic fields 52 may substantially terminate within electromagnetic field-attenuating particles 32. Additionally, although a particular number of electromagnetic fields 52 are illustrated, the present invention contemplates conductive connectors 26 emitting any suitable number and type of electromagnetic fields 52 and electromagnetic field-attenuating material 32 being operable to absorb one or more of such electromagnetic fields 52.

Returning to FIG. 1, encapsulating compound 28 may include any suitable amount of electromagnetic field-attenuating material 32. For example, encapsulating compound 28 may include any suitable ratio of packaging material 30 to electromagnetic field-attenuating material 32, according to particular needs, along with other suitable materials if desired or necessary. In certain embodiments, the amount of electromagnetic field-attenuating material 32 disposed within packaging material 30 may affect the amount of the electromagnetic fields (e.g., electromagnetic field 52) that is attenuated, which may affect the amount of EMI that is ultimately attenuated. The amount of electromagnetic field-attenuating material 32 may also affect the ability of packaging material 30 to mold and hold its shape to form encapsulating compound 28. Thus, there may be a threshold amount of electromagnetic field-attenuating material 32 at which encapsulating compound 28 includes too much electromagnetic field-attenuating material 32 for packaging material to mold and hold its shape to form encapsulating compound 28, depending on the type of materials 30 and 32 used.

Furthermore, the present invention contemplates encapsulating compound 28 including one or more portions in which electromagnetic field-attenuating materials is disposed within packaging material 30 and one or more portions in which no electromagnetic field-attenuating material 32 is disposed within packaging material 30. In addition or alternatively, different portions of packaging material 30 may contain different concentrations of electromagnetic field-attenuating material 32. In short, electromagnetic field-attenuating material 32 may be distributed throughout encapsulating compound 28 in any suitable amount and in any suitable manner, according to particular needs. As just one example, one layer of encapsulating compound 28 close to an integrated circuit chip may include magnetic field-attenuating material 32 and another layer of encapsulating compound 28 further from the integrated circuit chip may not include electromagnetic field-attenuating material 32. In certain embodiments, structure 10 may include one or more areas of higher sensitivity to interference or higher current relative to other areas of structure 10. For example, an area of high sensitivity to interference may include a receiving area of structure 10 and an area of high electrical current may include a transmitting area of structure 10. It may be desirable to perform multiple applications of encapsulating compound 28 such that these areas of higher sensitivity or higher current are surrounded by an encapsulating compound 28 that includes higher density of electromagnetic field-attenuating material 32. It may be desirable to cover conductive connectors 26 (e.g., bond wires) independently to minimize coupling between conductive connectors 26, or from one conductive connector 26 to another conductive connector 26. With respect to microwave packaging, for example, this may be referred to as a cavity or the use of a septum.

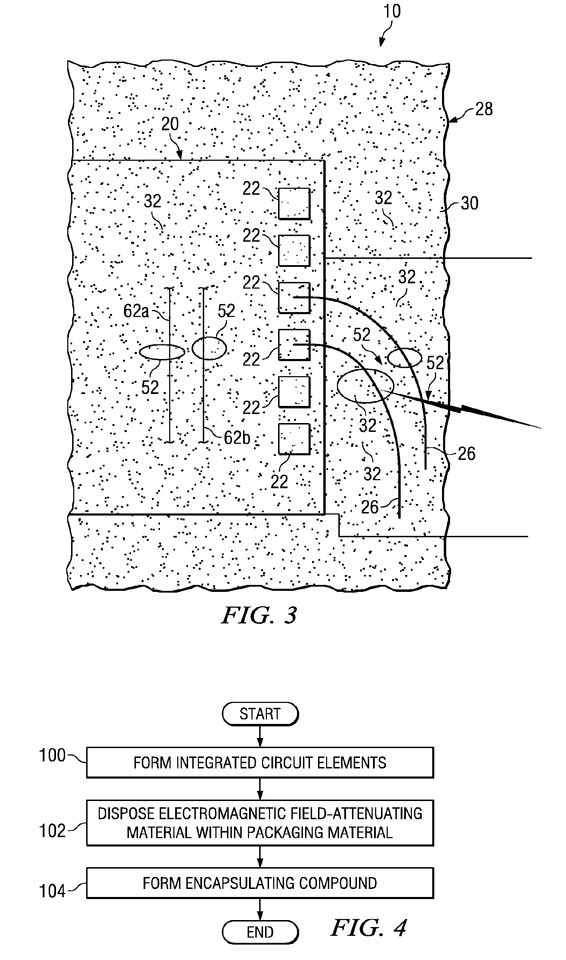

FIG. 3 illustrates a top view of an example integrated circuit structure 10 for attenuating EMI. In the illustrated embodiment, structure 10 includes die 20, bond pads 22, conductive connectors 26, and encapsulating compound 28 including packaging material 30 and electromagnetic field-attenuating material 32.

As discussed above with reference to FIGS. 1 and 2, disposing electromagnetic field-attenuating material 32 within packaging material 30 of package mold compound 28 of structure 10 may help attenuate electromagnetic fields emitted by one or more integrated circuit elements of structure 10 (e.g., electromagnetic fields 52 emitted by conductive connectors 26). For example, electromagnetic field-attenuating material 32 may attenuate magnetic coupling of conductive connectors 26.

Electromagnetic field-attenuating material may help attenuate electromagnetic field 52 from being emitted from structure 10. For example, in certain embodiments, multiple integrated circuit structures 10 may be included in an electrical device (e.g., on a printed circuit board). The present invention may help attenuate EMI between the multiple integrated circuit structures by attenuating electromagnetic fields 52 from being coupled between integrated circuit structures within structure 10 or from being emitted from integrated circuit structure 10.

Die 20 may include one or more metal or other traces 62 operable to carry an electrical signal. For example, traces 62 may be operable to carry an electrical signal within die 20 or into or out of die 20, according to particular needs. In certain embodiments, traces 62 may form routing tracks of die 20. In certain embodiments, traces 62 may be referred to as integrated circuit elements. Although a particular number of traces 62 are illustrated, the present invention contemplates structure 10 including any suitable number of traces 62.

Traces 62 may emit electromagnetic fields 52 in one or more directions when an electric current is applied to traces 62. For example, trace 62a may emit an electromagnetic field 52 when an electric current is applied to trace 62a, which may interfere with trace 62b or other components of structure 10 or any nearby electrical device. This interference may be referred to as electromagnetic coupling of trace 62a and trace 62b. In certain embodiments, electromagnetic field-attenuating material 32 is operable to attenuate electromagnetic coupling of trace 62a and trace 62b, for example. In certain embodiments, electromagnetic field-attenuating material 32 is operable to attenuate electromagnetic interference by attenuating electromagnetic fields 52 generated by traces 62.

Although particular integrated circuit elements of particular integrated circuit structures are described with reference to FIGS. 1-3, the present invention contemplates any suitable integrated circuit structures including any suitable integrated circuit elements. The present invention contemplates any suitable structure that includes an encapsulating compound comprising electromagnetic field-attenuating material 32, the electromagnetic field-attenuating material 32 attenuating EMI by attenuating electromagnetic fields 52 emitted by one or more elements of the structure.

Particular embodiments of the present invention may provide one or more technical advantages. In certain embodiments, the present invention may attenuate electromagnetic fields emitted by integrated circuit elements of an integrated circuit structure 10 (e.g., an integrated circuit chip), possibly attenuating electromagnetic field emissions 52 from integrated circuit structure 10 and the interference caused by electromagnetic field emissions 52. For example, improved fabrication dimensions of integrated circuit chips have enabled them to operate at higher frequency, often resulting in substantial spectral energy being generated from the integrated circuit chips. In certain embodiments, including electromagnetic field-attenuating material 32 in encapsulating compound 28 of integrated circuit structure 10 may attenuate the spectral energy and reduce the potential for interference caused by this energy. As another example, an integrated circuit chip may include circuits or other integrated circuit elements that are relatively close to one another (e.g., metal lines that are close to one another). The present invention may help reduce or eliminate undesirable electromagnetic coupling from one metal line to another on or within the integrated circuit chip.

In certain embodiments, the present invention reduces or eliminates the need for the often-expensive special metallic housing or metallic spray-paint enclosing an electrical device. Instead, certain embodiments of the present invention provide a relatively low-cost addition to typical package molding that offers electrical benefits to the normal packaging activity. For example, the present invention may reduce overall EMI by reducing EMI at the package level rather than at the system level (e.g., by surrounding an electrical device in a metal casing creating a Faraday shield). In certain embodiments, the present invention may provide a more cost-effective solution than enclosing entire integrated circuit structures 10 (e.g., an integrated circuit chip) in metal. In certain embodiments, the present invention may allow one or more integrated circuit structures 10 to be placed closer to one another, on a printed circuit board for example, by reducing or eliminating electromagnetic fields 52 emitted from each integrated circuit structure 10. Additionally, in particular embodiments, the present invention is less sensitive to integrated circuit fabrication variations than previous techniques such as balanced interconnect topology techniques, for example.

FIG. 4 illustrates an example method for forming an integrated circuit structure for attenuating EMI, such as integrated circuit structure 10 described with reference to FIGS. 1-3. At step 100, one or more integrated circuit elements may be formed. In certain embodiments, an integrated circuit structure 10 may be formed, including one a substrate layer 12, one or more leads 14, one or more solder bumps 16, one or more dies 20, one or more conductive connectors 26, or any other suitable or different integrated circuit elements. In certain embodiments, die 20 may include one or more metal or other traces 62.

At step 102, electromagnetic field-attenuating material 32 may be disposed within packaging material 30. For example, electromagnetic field-attenuating material 32 may be mixed with packaging material in any suitable manner. At step 104, encapsulating compound 28 may be formed in any suitable manner, at least a portion of encapsulating compound being formed with packaging material 30 in which magnetic field-attenuating material 32 is disposed. For example, encapsulating compound 28 may be molded or formed by injection molding, being dropped onto a bonded or flipped chip (e.g., by dropping globs of encapsulating material 28), or in any other suitable manner according to particular needs.

Although a particular method for forming integrated circuit structure 10 has been described with reference to FIG. 4, the present invention contemplates any suitable method for forming integrated structure 10 in accordance with the present invention. Thus, certain of the steps described with reference to FIG. 4 may take place simultaneously and/or in different orders than as shown. For example, electromagnetic field-attenuating material may be disposed within packaging material 30 as encapsulating compound 28 is formed. As another example, portions of encapsulating compound 28 may be formed with packaging material 30 in which electromagnetic field-attenuating material 32 is disposed while other portions of encapsulating compound 28 are formed with packaging material 30 that does not include electromagnetic field-attenuating material 32. Moreover, suitable methods may include those with additional steps, fewer steps, and/or different steps, so long as the methods remain appropriate.

## Claims

1. An integrated circuit structure, comprising:
one or more integrated circuit elements operable to generate an electromagnetic field when an electric current is applied to the integrated circuit element;
an encapsulating compound substantially surrounding the one or more integrated circuit elements, the encapsulating compound comprising:
a packaging material; and
an electromagnetic field-attenuating material operable to attenuate the electromagnetic field emitted by one or more of the integrated circuit elements, the electromagnetic field-attenuating material disposed within at least a portion of the packaging material.

2. The structure of Claim 1, wherein one or more of the integrated circuit elements comprises a bond wire, a conductive trace on an integrated circuit die, or other conductive connector coupling portions of the integrated circuit structure.

3. The structure of Claim 2, comprising at least two integrated circuit elements, the electromagnetic field-attenuating material of the encapsulating compound operable to attenuate electromagnetic coupling of the integrated circuit elements.

4. The structure of any of Claims 1 - 3, wherein the electromagnetic field-attenuating material is operable to attenuate an electromagnetic field emitted outside the structure by the one or more integrated circuit elements.

5. The structure of any of Claims 1 - 4 , wherein the electromagnetic field-attenuating material comprises a plurality of electromagnetic field-attenuating particles mixed into at least a portion of the packaging material of the encapsulating compound, one or more of the plurality of the particles operable to attenuate electromagnetic interference by attenuating electromagnetic fields.

6. The structure of Claim 5, wherein the electromagnetic field-attenuating particles are oriented to substantially optimally attenuate electromagnetic fields emitted by one or more integrated circuit elements.

7. The structure of any of Claims 1 - 6, wherein the electromagnetic field-attenuating material comprises a ferrite material.

8. A method for forming an integrated circuit structure, comprising:
forming one or more integrated circuit elements operable to generate an electromagnetic field when an electric current is applied to the integrated circuit element;
forming an encapsulating compound substantially surrounding the one or more integrated circuit elements, the encapsulating compound comprising:
a packaging material; and
an electromagnetic field-attenuating material operable to attenuate the electromagnetic field emitted by one or more of the integrated circuit elements, the electromagnetic field-attenuating material disposed within at least a portion of the packaging material.

9. The method of Claim 8, wherein the integrated circuit structure comprises at least two bond wires, conductive traces on an integrated circuit die, or other conductive connectors; and wherein the electromagnetic field-attenuating material of the encapsulating compound is operable to attenuate electromagnetic coupling of the conductive connectors.

10. The method of either Claim 8 or 9, wherein the electromagnetic field-attenuating material comprises a ferrite material.

11. The method of any of Claims 8 - 10, wherein:
the electromagnetic field-attenuating material comprises a plurality of electromagnetic field-attenuating particles, one or more of the plurality of the particles operable to attenuate electromagnetic interference by attenuating electromagnetic fields; and
the method further comprises mixing the electromagnetic field-attenuating particles into at least a portion of the packaging material of the encapsulating compound.

12. The method of Claim 11, further comprising orienting the electromagnetic field-attenuating particles to substantially optimally attenuate electromagnetic fields emitted by one or more integrated circuit elements.
